# FASCICULE DE BREVET EUROPEEN

(11) **EP 1 556 946 B1**
(45) Date de publication et mention de la délivrance du brevet: **14.12.2011**
(21) Numéro de dépôt: 03778463.4
(22) Date de dépôt: 27.10.2003
(51) Int. Cl.: H03H 2/00

(54) **DISPOSITIF A ONDES MAGNETOSTATIQUES BASE SUR DES FILMS MINCES METALLIQUES, PROCEDE DE FABRICATION ET APPLICATION A DES DISPOSITFS DE TRAITEMENT DE SIGNAUX HYPERFREQUENCES**
MAGNETOSTATISCHE VORRICHTUNG MIT METALLISCHEN DÜNNSCHICHTEN, HERSTELLUNGSVERFAHREN UND ANWENDUNG IN VORRICHTUNGEN ZUR VERARBEITUNG VON MIKROWELLENSIGNALEN
MAGNETOSTATIC WAVE DEVICE BASED ON THIN METAL FILMS, METHOD FOR MAKING SAME AND APPLICATION TO DEVICES FOR PROCESSING MICROWAVE SIGNALS

(30) Priorité: 28.10.2002 FR 0213486
(43) Date de publication de la demande: 27.07.2005
(73) Titulaire: Commissariat à l'Énergie Atomique et aux Énergies Alternatives, 75015 Paris (FR)
(72) Inventeur: BAILLEUL, Mathieu, 67000 STRASBOURG (FR); FERMON, Claude, F-91400 ORSAY (FR)
(74) Mandataire: Thévenet, Jean-Bruno
(86) Numéro de dépôt international: PCT/FR2003/003180
(87) Numéro de publication internationale: WO 2004/040756

(56) Documents cités:
- US-A- 3 157 865
- US-A- 4 188 594
- US-A- 4 283 692
- US-A- 4 853 660
- BAILLEUL M ET AL: "Spin waves propagation and confinement in conducting films at the micrometer scale" EUROPHYSICS LETTERS, 1 DEC. 2001, EUR. PHYS. SOC. BY EDP SCIENCES AND SOC. ITALIANA FISICA, FRANCE, vol. 56, no. 5, 1 décembre 2001 (2001-12-01), pages 741-747, XP008019276 ISSN: 0295-5075
- WEI WU ET AL: "Ferromagnetic Fe/Ag-GaAs waveguide structures for wideband microwave integrated notch filter devices" CONFERENCE PROCEEDINGS, 19 juin 2000 (2000-06-19), pages 51-52, XP010517453
- ISHAK W S: "MAGNETOSTATIC WAVE TECHNOLOGY: A REVIEW" PROCEEDINGS OF THE IEEE, IEEE. NEW YORK, US, vol. 76, no. 2, 1 février 1988 (1988-02-01), pages 171-187, XP000047990 ISSN: 0018-9219 cité dans la demande

## Description

La -présente invention concerne les dispositifs à ondes magnétostatiques, leur procédé de fabrication et leurs applications à des dispositifs de traitement de signaux hyperfréquences.

On connaît déjà divers dispositifs à ondes magnétostatiques utilisant des couches épaisses d'un matériau isolant ferrimagnétique à très faibles-pertes tel que le monocristal de grenat d'yttrium et de fer Y₃Fe₅O₁₂ (en abrégé, YIG) qui est lui-même formé par épitaxie en phase liquide sur un substrat non magnétique tel qu'un grenat de gadolinium et de gallium Gd₃Ga₅O₁₂ (en abrégé, GGG).

De tels dispositifs connus à ondes magnétostatiques sont décrits par exemple dans le document de Waguih S. Ishak intitulé "Magnetostatic Wave Technology: A Review", Proceedings of the IEEE, Vol. 76, No. 2, Février 1988.

Ces dispositifs à YIG ne sont pas facilement intégrables à un substrat semiconducteur et leur réalisation matérielle est très délicate et coûteuse. Ils sont à couche épaisse, de l'ordre de 5 µm. Le matériau étant à faible relaxation, les composants hyperfréquences qu'ils permettent de réaliser ont une atténuation relativement faible, environ 20 db. En outre, la commutation est limitée autour de la milliseconde en raison de leur taille.

taille. On connaît encore divers dispositifs à ondes magnétostatiques utilisant des ferrites, comme cela est indiqué par exemple dans l'article de Martha Pardavi-Morvath, intitulé "Microwave application of soft ferrites", paru dans le Journal of Magnetism and Magnetic Materials 215-216 (2000), pages 171-183.

-Toutefois, les dispositifs de ce type ne se prêtent pas non plus à une intégration aisée, présentent des couches de matériau ferrimagnétique épaisses, de l'ordre du millimètre.

Le document "Spin waves propagation and confinement in conducting films at the micrometer scale", par M. Bailleul et al., Europhysics Letters vol. 56, no. 5, pp. 741-747, 1er décembre 2001, décrit un dispositif intégré à ondes magnétostatiques comprenant un film mince ferromagnétique conducteur, dont l'épaisseur est de 35 nm, qui est disposé sur un substrat et associé à une première antenne transductrice de réception de signaux électriques hyperfréquences et à une deuxième antenne transductrice d'émission de signaux électriques hyperfréquences.

On connaît encore par le brevet US 4 853 660 des dispositifs hyperfréquences intégrables comportant un film de matériau ferromagnétique métallique disposé sur un substrat diélectrique.

Toutefois, selon ce document, il est prévu un seul élément d'entrée-sortie constitué par ruban amagnétique-couplé à un ruban ferromagnétique. L'atténuation d'ondes hyperfréquences se propageant le long de ce ruban est considérablement augmentée lorsque la matériau ferromagnétique satisfait la condition de résonance ferromagnétique (ici une résonance uniforme). Toutefois, l'existence d'un seul élément d'entrée-sortie limite fortement les applications d'un tel dispositif.

La présente invention vise à remédier aux inconvénients des dispositifs précités et à permettre de réaliser des dispositifs à ondes magnétostatiques facilement intégrables sur des substrats semiconducteurs selon les processus de fabrication de la microélectronique et permettant de travailler à des fréquences de travail plus élevées que les dispositifs à YIG.

L'invention vise encore à permettre la fabrication de différents types de dispositifs fonctionnels hyperfréquences ayant des performances satisfaisantes, tout en présentant un encombrement et un coût réduits.

Ces buts sont atteints conformément à l'invention grâce à un dispositif intégré à ondes magnétostatiques, caractérisé en ce qu'il comprend un substrat, un film mince ferromagnétique conducteur, d'épaisseur (e) comprise entre environ 250 et 450 nanomètres, et de préférence de l'ordre de 300 nanomètres, ce film mince étant disposé sur ledit substrat, une première antenne transductrice de réception de signaux électriques hyperfréquences, disposée parallèlement audit film mince ferromagnétique à proximité de celui-ci pour créer dans ce matériau, par couplage inductif, des ondes magnétostatiques ou des ondes de spin, et une deuxième antenne transductrice d'émission de signaux électriques - hyperfréquences, disposée parallèlement audit film mince ferromagnétique à proximité de celui-ci pour être couplée inductivement et délivrer des signaux électriques hyperfréquences lors de l'arrivée d'une onde magnétostatique dans le film mince ferromagnétique, ladite deuxième antenne étant située du même côté du film mince ferromagnétique que la première antenne de façon essentiellement coplanaire à cette dernière.

Le film mince ferromagnétique est de préférence en un alliage magnétique dont l'aimantation à saturation est supérieure ou égale à 0,6T.

Le film mince ferromagnétique est avantageusement en un alliage magnétique très doux tel que Ni₈₀ Fe₂₀.

Le film mince ferromagnétique présente une largeur (L) de l'ordre de quelques dizaines de micromètres.

La distance (e₃) entre d'une part les première et deuxième antennes transductrices et d'autre part le film mince ferromagnétique est de l'ordre de quelques dizaines à quelques centaines de nanomètres.

La distance d'écartement (D) entre les première et deuxième antennes transductrices est comprise entre environ 30 et 100 micromètres et de préférence voisine de 40 micromètres.

Les première et deuxième antennes - transductrices peuvent comprendre une âme centrale et deux conducteurs latéraux de masse parallèles à l'âme centrale et situés sans contact de part et d'autre de celle-ci.

L'âme centrale présente une largeur de l'ordre de quelques micromètres.

Chacune des première et deuxième antennes transductrices s'étend sur toute la largeur (L) du film mince ferromagnétique et occupe dans le sens longitudinal de ce film un espace dont la largeur est inférieure à ladite distance d'écartement (D) et peut être compris entre environ 10 et 60 micromètres.

Selon un mode de réalisation particulier, l'une au moins des première et deuxième antennes transductrices présente une forme de serpentin avec une succession de branches s'étendant dans le sens de la largeur (L) du film mince ferromagnétique.

La fréquence des ondes hyperfréquences peut être comprise entre environ 1 GHz et 100 GHz.

Le dispositif selon l'invention réalisé de façon intégrée peut comprendre un substrat semiconducteur.

Selon un mode de réalisation particulier qui permet la mesure des pertes et d'en déduire la relaxation magnétique, le dispositif comprend une troisième antenne transductrice disposée parallèlement audit film mince ferromagnétique à proximité de celui-ci pour être couplée inductivement et délivrer des signaux électriques hyperfréquences lors de l'arrivée d'une onde magnétostatique dans le film mince ferromagnétique, ladite troisième antenne étant située du même côté du film mince ferromagnétique que les première et deuxième antennes en étant interposée entre celles-ci de façon coplanaire.

Le dispositif selon l'invention peut être appliqué à un atténuateur ou un commutateur commandable par un courant et dans ce cas comprend en outre des premiers moyens d'application d'un champ magnétique (H_{A}) transversal dans le sens de la largeur (L) du film mince ferromagnétique, des seconds moyens d'application d'un champ magnétique (H_{B}) longitudinal dans le sens de la longueur du film mince ferromagnétique et des moyens de commande d'au moins l'un des premiers et deuxièmes moyens d'application d'un champ magnétique pour modifier sélectivement les caractéristiques du champ magnétique résultant (H_{R}) agissant sur le film mince ferromagnétique.

Le dispositif selon l'invention peut encore être appliqué à un isolateur ou un circulateur (auquel cas au moins une troisième antenne transductrice est ajoutée). Le dispositif comprend alors des moyens pour orienter un champ magnétique appliqué au film mince ferromagnétique de telle manière qu'il y ait non réciprocité des première et deuxième antennes transductrices, un signal d'ondes magnétostatiques n'étant transmis de façon significative que de la première antenne vers la seconde antenne. Cette non-réciprocité peut être en particulier obtenue lorsque le champ est appliqué dans le plan du film, perpendiculairement à la direction de propagation des ondes (configuration dite des ondes magnétostatiques de surface).

Le dispositif selon l'invention peut également comprendre un film mince ferromagnétique conducteur en un matériau présentant par anisotropie cubique plusieurs états stables et un tel dispositif peut être appliqué à un commutateur commandable par un courant, des moyens étant prévus pour appliquer des impulsions de champ magnétique afin de faire basculer le film mince d'un état stable à l'autre.

Ainsi - la présente invention permet de réaliser des composants hyperfréquences pour télécommunications, qui sont à la fois intégrables, à hautes performances et de faible coût.

L'invention permet ainsi de réaliser par exemple des commutateurs intégrables aux performances en commutation améliorées, avec une atténuation de l'ordre de 40 à 50 dB lorsque l'interrupteur est ouvert et un temps de basculement de l'ordre de la nanoseconde. De tels commutateurs peuvent aussi être utilisés en tant qu'atténuateurs compte tenu de l'étendue de la plage d'atténuation.

Dans cette application, l'invention exploite le caractère de non réciprocité de la propagation de certaines ondes magnétostatiques. Pour une certaine orientation du champ magnétique appliqué au film ferromagnétique, le signal se transmet de la première antenne vers la deuxième antenne, mais se trouve affaibli d'un facteur pouvant atteindre 20 dB dans le sens inverse de la deuxième antenne vers la première antenne. Ceci permet de réaliser des isolateurs et des circulateurs de coût bien inférieur aux dispositifs du même type réalisés en technologie YIG.

Au contraire des dispositifs utilisant des isolants tels que le YIG, les dispositifs selon l'invention, par le caractère -métallique du film ferromagnétique, peuvent être conçus de manière à bénéficier de l'effet de peau de ce film et peuvent en tirer profit grâce à la mise en oeuvre d'au moins deux antennes. Au-delà de la profondeur de peau, l'épaisseur du matériau se comporte comme un miroir qui canalise les ondes en surface. Lorsqu'elles parcourent le film ferromagnétique de la deuxième antenne vers la première antenne, les ondes sont de même canalisées sur la surface opposée aux antennes et ne se mélangent aucunement aux ondes circulant sur la surface en regard des antennes.

La nature métallique du matériau ferromagnétique se traduit par une très forte atténuation, principalement due aux électrons. Ceci est un désavantage lorsque les distances de propagation sont élevées, mais n'en n'est plus un si elles sont très courtes. Les faibles dimensions du dispositif sont ainsi particulièrement adaptées aux fortes déperditions d'énergie du matériau.

Des dispositifs à ondes magnétostatiques selon l'invention, qui peuvent être placés dans des régimes de fort couplage et de forte non-réciprocité, sont ainsi aptes à une fabrication sous la forme de dispositifs totalement intégrés d'une centaine de micromètres de côté avec des pertes d'insertion de quelques décibels et une sélectivité d'au moins une vingtaine de décibels.

D'autres caractéristiques et avantages de l'invention ressortiront de la description suivante de modes particuliers de réalisation, donnés à titre d'exemples, en référence aux dessins annexés, sur lesquels :
- la Figure 1 est une vue schématique de dessus montrant un exemple de réalisation d'un dispositif à ondes magnétostatiques selon l'invention avec un film ferromagnétique conducteur et deux antennes transductrices coplanaires,
- la Figure 2 est une vue en coupe selon la ligne II-II de la Figure 1,
- la Figure 3 est une vue de dessus d'un exemple d'antenne utilisable dans le cadre du dispositif selon l'invention,
- la Figure 4 est une vue schématique de dessus d'un exemple de dispositifs à ondes magnétostatiques à trois antennes permettant notamment d'évaluer des pertes et de caractériser la relaxation des ondes,
- la Figure 5 est une vue schématique d'un exemple d'application du dispositif selon l'invention à un atténuateur commandable par un courant,
- la Figure 6 est une vue schématique de dessus d'un exemple d'application du dispositif selon l'invention à un circulateur à champ magnétique radial et dans le plan du circulateur,
- les Figures 7A à 7J illustrent différentes étapes d'un exemple de procédé de fabrication d'échantillons intégrés de motifs magnétiques et d'antennes pouvant constituer des éléments des dispositifs selon l'invention,
- la Figure 8 est un ensemble de courbes donnant la dispersion d'un matériau magnétique pour plusieurs modes de propagation, et
- la Figure 9 est un ensemble de courbes donnant la transmission des ondes magnétostatiques en fonction de la distance entre antennes.

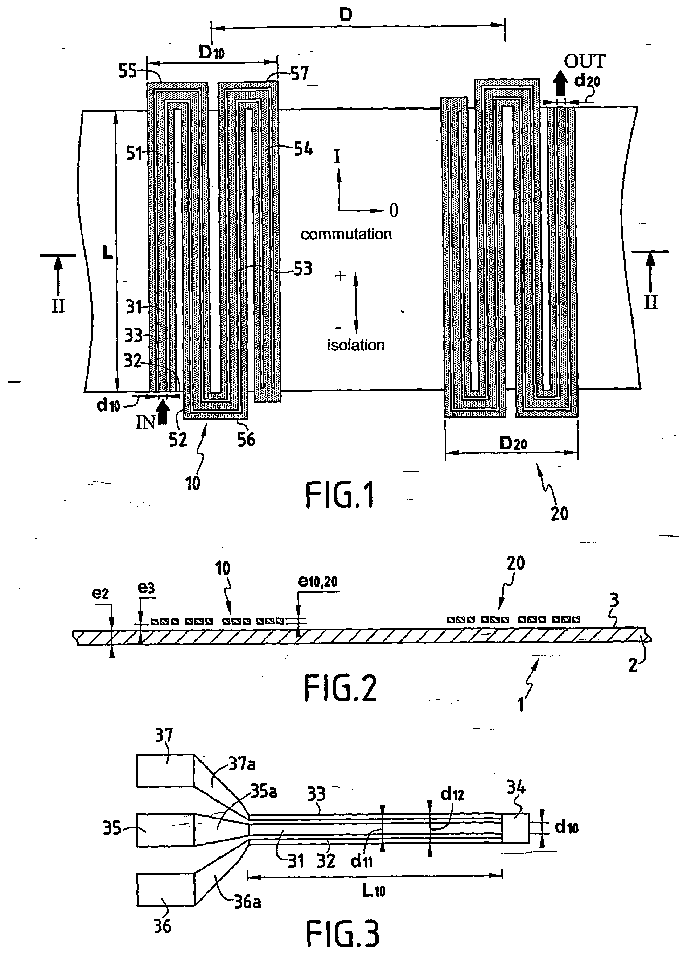

Selon une caractéristique -essentielle de la présente invention, il est mis en oeuvre un film mince 2 de matériau ferromagnétique conducteur (Figures 1 et 2).

On peut avantageusement utiliser un film de permalloy Ni₈₀ Fe₂₀ qui est un alliage magnétique très doux ayant une aimantation à saturation de l'ordre de 1 T. Toutefois, en fonction des applications, d'autres matériaux ferromagnétiques métalliques pourraient être utilisés, tels que par -exemple du fer épitaxial qui présente des pertes un peu moins importantes.

Plus généralement, l'invention est applicable à tous les matériaux ferromagnétiques conducteurs ; toutefois en pratique, son fonctionnement n'est satisfaisant que lorsque le matériau ferromagnétique utilisé possède une aimantation à saturation supérieure ou égale à 0,6 T. Il est avantageux d'utiliser les matériaux dont l'aimantation à saturation est la plus élevée possible. Des tests de fonctionnement ont notamment été réalisés avec du fer pur à 2,2 T et du cobalt pur à 1,7 T. Les alliages de ces métaux sont bien adaptés à l'invention.

Dans le cas de matériaux métalliques, l'amortissement s'avère toujours plus élevé que dans le YIG, ce qui est généralement attribué au caractère itinérant des électrons.

Ainsi, dans un échantillon métallique, les champs électromagnétiques haute fréquence sont écrantés par les électrons de conduction sur une distance égale à la profondeur de peau. Le mode de résonance correspondant a un caractère évanescent dans la direction normale à la couche et il est décrit par un vecteur d'onde k_{FOUC} ayant une composante imaginaire non nulle. Les courants de Foucault peuvent également contribuer à l'amortissement d'une onde se propageant le long de la surface de l'échantillon, l'influence de ces courants de Foucault étant particulièrement grande si l'épaisseur du film, la longueur d'onde de l'onde magnétostatique et la profondeur de peau sont du même ordre de grandeur.

On notera également qu'à une échelle plus microscopique, le caractère itinérant des électrons se traduit par des processus de diffusion électron-magnons par les ondes de spin qui n'existent pas dans les isolants et augmentent la relaxation.

L'utilisation du permalloy comme film mince ferromagnétique présente des avantages intéressants. Ce matériau est en effet un alliage de nickel et de fer qui présentent des magnétostrictions non nulles et opposées. Pour un mélange contenant environ 20% de fer, les contributions magnétostrictives des deux éléments se compensent. Il est produit en outre un phénomène similaire pour l'anisotropie magnétocristalline. Ces propriétés présentent un avantage pratique important sauf précautions particulières, les matériaux fabriqués sont en effets polycristallins ne présentant ni anisotropie, ni magnétostriction (matériau dit "doux"), de sorte que le permalloy a des propriétés presque idéales même sous forme polycristalline.

Des films minces de permalloy peuvent être obtenus par des techniques de dépôt par pulvérisation et présentent des propriétés très voisines de celles du permalloy massif.

Un film mince 2 peut être déposé sur un substrat (Figure 2) - pouvant être par exemple en verre ou en silicium. Il se prête tout à fait à des dépôts sur des substrats semiconducteurs utilisés dans le cadre des techniques de la microélectronique.

Comme on peut le voir sur les Figures 1 et 2, un dispositif selon l'invention comprend deux antennes transductrices coplanaires 10, 20 situées à proximité du film mince ferromagnétique 2 parallèlement à celui-ci de manière à être couplées inductivement à ce dernier.

Chaque _antenne 10, 20 est située à une faible distance e₃ de la même face du film ferromagnétique 2.

Chaque antenne 10, 20 est disposée transversalement par rapport au film ferromagnétique 2 et s'étend sur toute la largeur de ce dernier. Elle présente ainsi une longueur au moins égale à la largeur L du film 2. La deuxième antenne 20 d'émission délivre des signaux électriques hyperfréquences lors de l'arrivée d'une onde magnétostatique dans le film 2.

Les ondes hyperfréquences appliquées à l'antenne 10 et émises par l'antenne 20 peuvent se situer dans un domaine de fréquences comprises entre 1 GHz et 20 GHz et être par exemple-de l'ordre de 8 GHz mais peuvent aussi être comprises dans un domaine de fréquences plus élevées comprises entre 20 GHz et 100 GHz.

Les antennes 10, 20 représentées sur les Figures 1 et 2, ainsi que sur l'exemple particulier de la Figure 3, sont du type guide d'onde coplanaire à plan de masse interrompu.

Si l'on considère le cas de la Figure 3 qui représente une antenne avec une seule branche transversale, on voit que sa réalisation coplanaire facilite la réalisation puisqu'elle n'implique pas d'étapes de lithographie supplémentaires comme ce serait le cas avec des antennes comportant un conducteur de masse situé dans un plan différent de celui de l'âme centrale.

-L'antenne 10 représentée sur la Figure 3 présente une configuration symétrique du guide d'onde coplanaire avec un plan de masse 32, 33 situé de part et d'autre du conducteur central 32, mais une telle configuration n'est pas obligatoire. Par ailleurs, les dimensions des conducteurs du plan de masse 32, 33 ont été limitées pour éviter que les ondes de spin ne se propagent sous un vaste plan métallique. Une extrémité de l'antenne est munie d'un court-circuit 34 tandis que l'âme centrale 31 et les conducteurs latéraux du plan de masse 32, 33 sont prolongés à l'autre extrémité par des pistes plus larges 35a 36a 37a de liaison à des plots de connexion 35, 36, 37.

La largeur L du film mince ferromagnétique peut être comprise entre quelques dizaines et quelques centaines de micromètres. La largeur L peut ainsi être typiquement égale à 100 µm.

- La distance e₃ de couplage entre d'une part les antennes transductrices 10, 20 et d'autre part le film mince 2 peut être de l'ordre de quelques dizaines de nanomètres à quelques centaines de nanomètres et par exemple typiquement de 100 nanomètres.

L'épaisseur e_{10, 20} des éléments composant les antennes 10, 20 peut être par exemple de l'ordre de 500 nanomètres.

- L'âme centrale 31 des antennes 10, 20 peut comprendre une largeur d₁₀ de l'ordre de quelques micromètres, par exemple 3,5 ou 4 µm.

La largeur des conducteurs latéraux de masse 32, 33 n'est pas critique. A titre d'exemple, la distance du entre les faces internes des conducteurs de masse 32, 33 peut être de l'ordre de 8,5 µm tandis que la distance d₁₂ entre les faces externes des conducteurs de masse 32, 30 peut être de l'ordre de 12,5 µm.

Chaque antenne 10, 20 peut s'étendre sur une longueur L₁₀ légèrement supérieure à la largeur L du-film 2.

La distance d'écartement D (Figure 1) entre les antennes 10 et 20 est comprise entre 30 et 100 micromètres et peut de préférence être voisine de 40 µm.

Chaque antenne 10, 20 occupe dans le sens longitudinal du film un espace dont la largeur est inférieure à la distance d'écartement D et qui est compris de préférence entre 10 et 60 micromètres.

Comme on l'a représenté sur les Figures 1 et 2, chaque antenne 10, 20 peut présenter une forme plus complexe que celle de la Figure 3 et peut ainsi présenter une forme de serpentin avec une succession de branches parallèles 51, 52, 53, 54 s'étendant dans le sens de la largeur L du film 2 et réunies par de courtes portions de liaison 55, 56, 57 alternativement de part et d'autre du film 2. Ceci permet d'accroître la longueur totale de chaque antenne et par son caractère périodique, d'accroître sa sélectivité en limitant le nombre des vecteurs d'onde sur lesquels est répartie l'énergie injectée, de sorte que l'efficacité de la transduction peut être améliorée.

Dans l'exemple des Figures- 1 et 2, l'écartement D entre les antennes 10, 20 peut être par exemple de l'ordre de 75 µm et la largeur D₁₀, D₂₀ de chaque antenne 10, 20 en forme de serpentin dans le sens longitudinal du film 2 peut être par exemple de l'ordre de 50 µm.

Le repliement des antennes 10, 20 en plusieurs branches d'un serpentin a pour effet de réduire la bande passante autour de la résonance.

Dans le type d'antenne des Figures 1 à- 3, la largeur des deux conducteurs de masse 32, 33 est considérablement réduite, et les masses des deux antennes qui se trouvent disjointes ne sont connectées à la masse générale du circuit qu'en des points électriquement très éloignés, pour mieux contrôler la dispersion des ondes de spin.

On donnera ci-dessous quelques indications concernant la conception d'un dispositif à ondes magnétostatiques à deux antennes coplanaires 10, 20 telles que celles des Figures 1 et 2.

La variable initiale est la fréquence de travail des ondes hyperfréquences. La première étape de conception réside dans la détermination du pas des antennes (nécessairement accordées sur la même fréquence, mais pouvant être réalisées à l'aide de technologies différentes). Entre un brin "aller" transversal à l'axe du film, et le brin "retour", il existe selon l'axe du film une distance p qui constitue le pas de l'antenne. Ce pas p doit être égal à 2π divisé par le module du vecteur d'onde Q qui représente l'amplitude des oscillations que l'on souhaite créer dans le matériau magnétique. Préalablement à la conception proprement dite, une mesure est effectuée des variations de la fréquence de résonance f₀ en fonction de l'amplitude Q du vecteur d'onde et du mode d'onde, la valeur H du champ magnétique de polarisation étant un paramètre. Pour chaque valeur du champ magnétique, il existe plusieurs courbes correspondant chacune à un mode d'onde. A partir de la fréquence, on choisit donc un module Q de vecteur d'onde permettant une propagation des ondes magnétostatiques dans le film que l'on juge acceptable. Le pas de l'antenne en découle alors par la relation ci-dessus.

En pratique, on peut préférer une autre courbe équivalente, représentant les variations de la fréquence de résonance f₀ en fonction de la valeur H du champ magnétique de polarisation, l'amplitude Q du vecteur d'onde étant un paramètre. On obtient ainsi plusieurs courbes correspondant à plusieurs modes d'ondes. A partir de la fréquence, on choisit un mode d'onde permettant de fonctionner avec le pas d'antenne et le champ magnétique que l'on juge acceptable.

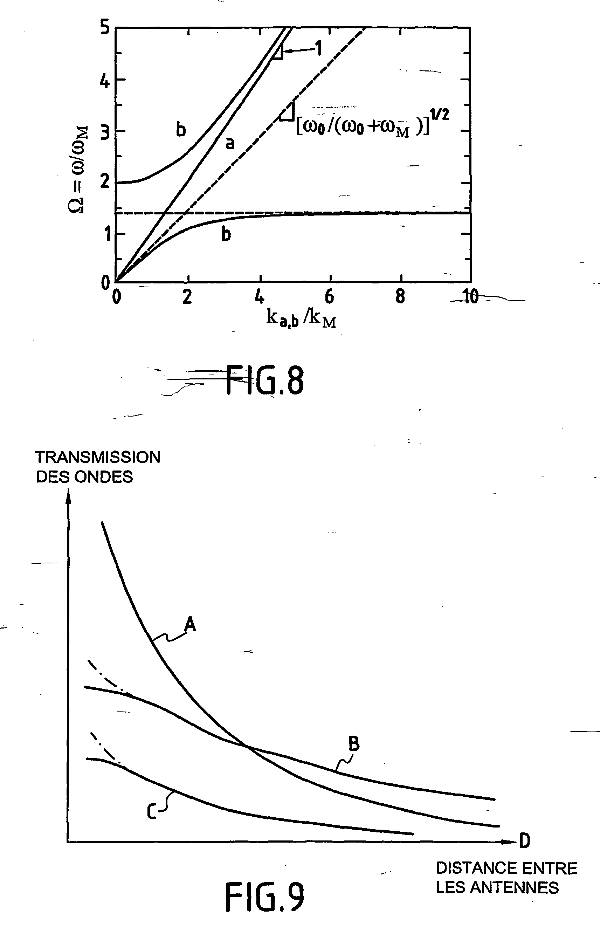

La deuxième étape de la conception consiste à déterminer la distance D entre les deux antennes. Lorsque cette distance D croît, l'amplitude de l'onde transmise décroît exponentiellement (amplitude de la forme A₀e^{-D}). D'autre part, l'amplitude de l'onde parasite transmise directement d'antenne à antenne par l'onde est de la forme A₀D⁻ⁿ, cette amplitude étant diminuée significativement (par exemple divisée par un facteur de l'ordre de 1,5 à 5 ou 10) si l'on interpose entre les deux antennes une électrode de masse, reliée à la masse électrique en un point éloigné du point où sont raccordées les masses des deux antennes. On choisit donc dans cette seconde étape quel est le niveau de transmission parasite par l'air que l'on tolère (ce qui revient à déterminer un seuil de bruit acceptable). En s'autorisant ce niveau de transmission parasite, on trace sur la Figure 9 une horizontale qui coupe en un point de fonctionnement une courbe A dont l'abscisse donne la distance. Pour cette distance, on peut trouver la valeur de la transmission des ondes dans le film, et si elle est trop faible, améliorer le blindage entre les deux antennes avant de réitérer cette seconde étape. On peut également revenir à la première étape en modifiant dans le sens approprié une des grandeurs d'entrée.

Sur la Figure 9, trois courbes A, B, C représentent la transmission des ondes en fonction de la distance D entre les-antennes 10, 20.

La courbe A représente la transmission dans le film ferromagnétique 2.

La courbe B représente la transmission dans l'air, sans qu'aucune électrode de masse soit interposée entre les antennes 10, 20.

La courbe C représente la transmission dans l'air, lorsqu'une électrode de masse additionnelle est interposée entre les antennes 10, 20.

La propagation des ondes magnétostatiques dans le film métallique magnétique mince 2 dépend de l'épaisseur de ce film. Les propriétés du dispositif selon l'invention dépendent du changement de comportement de ce film au voisinage des fréquences de résonance magnétique. Au maximum de la résonance, le comportement magnétique du film est comparable au comportement d'un "circuit bouchon résonant" en radiofréquences.

Une troisième étape de conception consiste à régler la longueur totale des antennes de telle manière que celles-ci aient, en résonance, une impédance d'entrée proche de l'impédance caractéristique des lignes de transmission utilisées dans l'application visée (par exemple 50 ohms). Cette précaution assure que la puissance hyperfréquence injectée dans la première antenne est totalement transférée dans le film magnétique et que rien n'est réfléchi. Ceci permet également que toute la puissance transmise par les ondes magnétostatiques soit transférée à la deuxième antenne sans que rien ne soit réfléchi dans le- film. On s'assurera également que les pertes ohmiques dans les antennes restent faibles devant la puissance transférée aux ondes magnétostatiques, de manière à limiter les pertes d'insertion.

En ce qui concerne l'épaisseur du film ferromagnétique 2, on peut noter que si la couche dépasse une certaine épaisseur (supérieure à 1 µm pour le NiFe/Fe), les courants de Foucault augmentent et conduisent à une relaxation plus importante. Une épaisseur préférentielle se situe entre 300 et 600 nanomètres. A titre indicatif, les dispositifs à YIG ont une épaisseur de 5 µm, et les dispositifs à ferrites de l'ordre de quelques millimètres.

Des résultats satisfaisants peuvent être obtenus avec des - épaisseurs e₂ du film 2 comprises entre environ 250 et 450 nanomètres et de préférence de l'ordre de 300 nanomètres, qui constituent de bons compromis afin d'obtenir un couplage suffisant avec les antennes 10, 20 sans que par ailleurs les courants de Foucault induits dans l'épaisseur du film 2 soient trop importants.

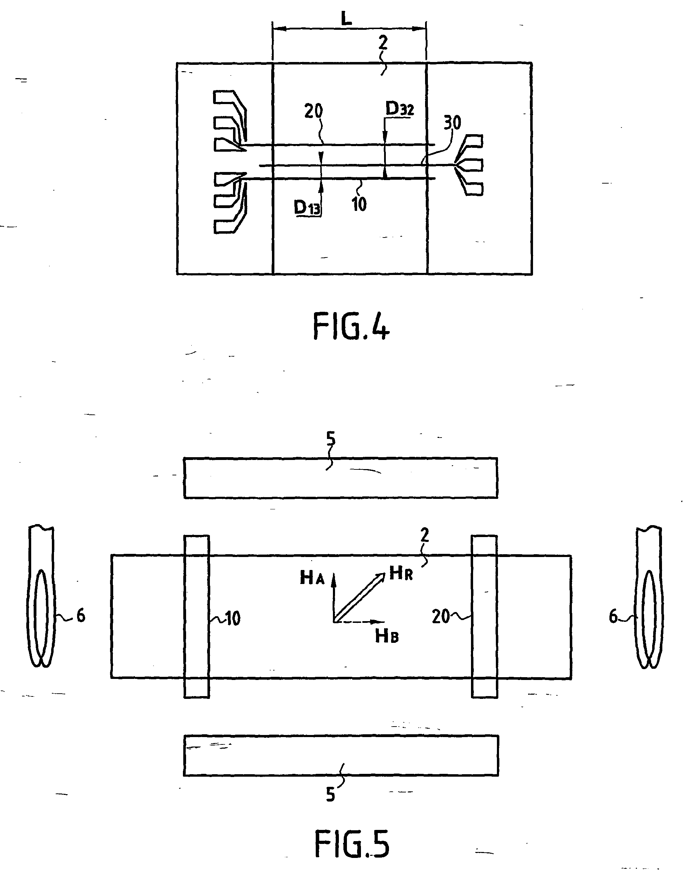

La Figure 4 montre un mode de réalisation particulier d'un dispositif à ondes magnétostatiques selon l'invention dans lequel on a disposé en superposition à un film mince ferromagnétique conducteur 2, par exemple en permalloy, non seulement deux antennes transductrices coplanaires 10, 20 pouvant présenter par exemple la configuration de la Figure 3, mais également une troisième antenne transductrice 30 qui est également coplanaire aux antennes 10, 20, présente une configuration qui peut être similaire à celles-ci et qui est interposée entre les antennes 10 et 20. La troisième antenne 30 s'étend transversalement sur toute la largeur du film 2 comme les antennes 10 et 20.

A titre d'exemple, avec un film 2 de largeur 700 µm, le distance D₁₃ entre les première et troisième antennes 10, 30 peut être de l'ordre de 50 µm et la distance D₃₂ entre les troisième et deuxième antennes 30, 20 peut être de l'ordre de 100 µm. Ces distances ne sont naturellement données qu'à titre d'exemples.

La présence d'une troisième antenne hyperfréquence 30 permet, en combinaison avec les première et deuxième antennes 10, 20, d'effectuer des mesures de pertes réelles au sein du dispositif et d'en déduire la relaxation des ondes, ce qui permet ensuite d'ajuster les valeurs de certains paramètres du dispositif, telle que la distance entre les antennes principales 10, 20.

Dans le cas de trois antennes 10, 20, 30, une antenne peut être utilisée en émission des ondes magnétostatiques tandis que les deux autres antennes peuvent être utilisées en réception-après des trajets des ondes magnétostatiques sur des distances différentes au sein du film 2. Un tel dispositif est donc essentiellement utilisé dans le cadre de développements ou de mises au point de nouveaux dispositifs hyperfréquences.

D'une manière générale, en mesurant le signal transmis entre deux antennes 10, 20, il est possible d'observer directement la propagation d'un paquet d'ondes de spin. On peut ainsi mesurer le retard propagatif (Δt), l'atténuation propagative (en comparant l'amplitude transmise à l'amplitude de la résonance mesurée en réflexion) et évaluer la non réciprocité en champ.

Cette dernière propriété est une particularité des ondes magnétostatiques de surface (propagation perpendiculaire au champ appliqué, ces deux vecteurs étant dirigés dans le plan du film) : celles-ci sont en effet évanescentes dans l'épaisseur du film. Elles sont donc localisées plus particulièrement sur une des surfaces de la couche (surface supérieure dans un sens de propagation, surface inférieure dans l'autre). En changeant le sens de propagation (ou en changeant le sens du champ appliqué, ce qui revient au même), on peut ainsi changer la surface près de laquelle se propage l'onde. Or, les antennes transductrices 10, 20 étant situées au-dessus du film 2, elles se couplent mieux à la face supérieure du film.

Malgré la relaxation élevée dans les films métalliques, les dispositifs selon l'invention permettent d'obtenir des résultats particulièrement avantageux dès lors que les antennes sont réalisées avec des dimensions suffisamment petites et sont disposées avec un écartement optimisé comme indiqué plus haut.

On décrira ci-dessous divers exemples d'applications du dispositif selon l'invention à des dispositifs de traitement de signaux hyperfréquences.

On a représenté sur la Figure 5 le schéma de principe d'un atténuateur commandable par un courant. Dans ce cas, on associe un dispositif de base comprenant un film mince ferromagnétique conducteur 2 et deux antennes transductrices coplanaires 10, 20, tel que décrit plus haut, à des premiers moyens 5, tels qu'une paire d'aimants permanents ou de bobines d'électroaimant, pour appliquer un champ magnétique H_{A} transversal dans le sens de la largeur L du film 2. On dispose en outre une paire de bobines d'électroaimants 6 pour appliquer un champ magnétique H_{B} longitudinal dans le sens de la longueur du film 2. Des moyens de commande sont associés par exemple aux bobines 6 pour modifier sélectivement les caractéristiques du champ magnétique H_{B} et par suite les caractéristiques du champ magnétique résultant H_{R} agissant sur le film 2. Les moyens de commande peuvent aussi agir de-façon alternative sur des bobines d'électroaimant des moyens 5 d'application du champ magnétique H_{A}, voire à la fois sur l'ensemble des moyens 5 et 6.

Dans un tel dispositif atténuateur, la valeur de l'atténuation est ainsi déterminée par l'intensité ou préférentiellement l'orientation du champ magnétique uniforme de polarisation. Comme on l'a indiqué, un mode de réalisation simple peut comprendre une polarisation magnétique transversale appliquée de façon permanente et une polarisation axiale variable ajoutée de façon à modifier l'orientation du champ magnétique résultant.

Un dispositif commutateur peut être réalisé de la même manière, la commutation s'opérant en coupant complètement la transmittivité du dispositif en se plaçant hors résonance, comme c'est le cas si l'on provoque une rotation de 90° de l'aimantation de la couche, par exemple en interrompant complètement l'application du champ magnétique - transversal par les bobines d'électroaimant 5 lorsque l'on applique simultanément le champ magnétique longitudinal par les bobines d'électroaimant 6.

Un dispositif commutateur peut comprendre à titre de variante une couche mince de matériau ferromagnétique conducteur 2 ayant plusieurs états stables à rémanence (anisotropie cubique) et des moyens d'application d'une impulsion de champ magnétique pour passer d'un état stable à l'autre.

L'invention est également applicable à des dispositifs de traitement de signaux hyperfréquences du type passif tels que des isolateurs ou des circulateurs dans lesquels lorsqu'on envoie une onde incidente dans le système, celui-ci coupe l'onde réfléchie.

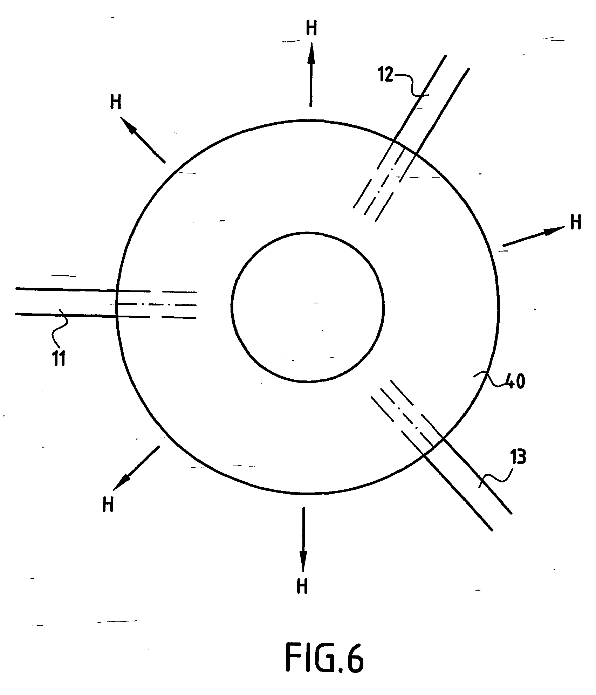

La Figure 6 montre schématiquement un exemple de circulateur pouvant être réalisé conformément à l'invention avec un film mince ferromagnétique conducteur 40 plan qui, au lieu d'être linéaire, présente la forme d'une couronne. Des antennes transductrices coplanaires 11, 12, 13 semblables aux antennes transductrices 10, 20 sont réparties autour de la couronne 40 et s'étendent transversalement-à celle-ci.

On applique un champ magnétique radial dans le plan du circulateur. L'efficacité peut être de l'ordre de 20 dB ou plus.

Le nombre d'antennes transductrices 11, 12, 13 peut être égal à 3 ou être plus élevé selon les applications envisagées.

Dans le cas d'un circulateur à trois antennes 11, 12, 13 tel que celui de la Figure 6, le fonctionnement peut être le même qu'avec des circulateurs connus utilisant dès ferrites, c'est-à-dire qu'un signal introduit par l'antenne 11 sera transmis par le champ magnétique rotatif vers l'antenne 12 mais pas vers l'antenne 13. Un signal appliqué par l'antenne 12 sera transmis vers l'antenne 13 mais pas vers l'antenne 11, etc.

Par son caractère intégrable, le dispositif circulateur selon l'invention peut être réalisé à faible coût et sous une forme miniaturisée.

Des isolateurs peuvent être réalisés de la même façon que des circulateurs.

On indiquera à nouveau les différences entre les dispositifs connus à ondes magnétostatiques dans le YIG ou dans des ferrites et les dispositifs à film ferromagnétique conducteur mince selon l'invention, en référence à la Figure 8 qui montre des courbes a et b donnant la pulsation Ω en fonction du module de vecteur d'onde magnétostatique k.

Pour la même fréquence, on a un vecteur d'onde beaucoup plus élevé dans le cas des ondes magnétostatiques.

Cette courbe donne la dispersion du matériau pour plusieurs modes de propagation, c'est-à-dire la courbe de la pulsation correspondant à chaque module de vecteur d'onde magnétostatique. On constate que cette courbe a trois branches. La courbe a correspond à un mode électromagnétique modifié par les propriétés gyromagnétiques du film ferromagnétique (on retrouve une relation omega = ck comme pour les ondes lumineuses), c'est la branche qui est utilisée pour faire fonctionner les dispositifs à ferrites (comme les circulateurs à jonction Y). La courbe b comporte deux branches. Celle du dessus est celle des ondes - magnétostatiques. Pour un vecteur-d'onde nul, on retrouve une fréquence de résonance non nulle : c'est la résonance ferromagnétique, telle qu'elle est utilisée dans le brevet US 4 853 660. A vecteur d'onde un peu plus élevé, on retrouve des modes magnétostatiques propagatifs, qui sont utilisés par les dispositifs à YIG et selon l'invention.

Dans les circulateurs (dits à jonction Y) connus, à ferrites, le mode stationnaire électromagnétique impose une longueur d'onde de travail λ telle que λ soit du même ordre de grandeur que le diamètre de la pastille magnétique. Ce mode stationnaire électromagnétique impose sans ferrite un λ supérieur à 1 cm, et avec une ferrite, un λ variant avec la perméabilité magnétique de la ferrite, mais que l'on peut situer autour de quelques mm.

A l'opposé, dans un circulateur selon l'invention, le mode stationnaire électromagnétique impose une longueur d'onde de travail λ telle que λ soit du même ordre de grandeur que le pas de l'antenne. A titre indicatif, ce mode magnétique pur impose, pour une fréquence de 3 GHz un λ, de l'ordre de 100 µm avec un film magnétique métallique d'épaisseur 300 nm.

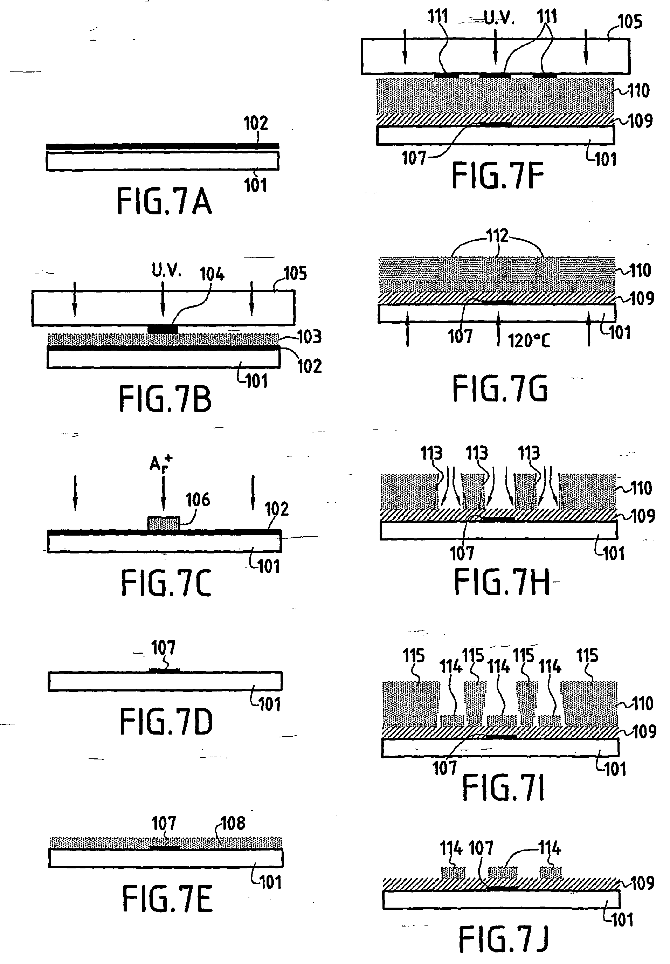

On donnera ci-dessous à titre d'exemple en référence aux Figures 7A à 7J un procédé de fabrication permettant de fabriquer des échantillons intégrés comportant des motifs magnétiques tels que le film mince ferromagnétique conducteur 2 des Figures- 1 et 2 et des antennes telles que les antennes des Figures 1 à 3.

Sur la Figure 7A, on voit une première étape dans laquelle une couche de Ni₈₀ Fe₂₀ est déposée par évaporation sur un substrat de verre.

Sur la Figure 7B, on voit une deuxième étape dans laquelle les motifs magnétiques sont écrits par la technique de lithographie optique positive. Une couche 103 de résine photosensible st déposée sur la couche de Ni₈₀ Fe₂₀. Un masque 104 est disposé sur la couche de résine 103 et l'ensemble est éclairé par une lampe ultraviolette 105 pour dégrader la résine photosensible 105 dans les zones non protégées par le masque 104. Les zones isolées sont ensuite dissoutes. Il ne reste de la résine 106 que dans les zones initialement protégées par les motifs métalliques du masque 104.

Sur la Figure 7C, l'échantillon est érodé par gravure ionique.

Etant donné le rapport d'épaisseur entre les couches 102 et 104, le film de résine optique restant 106 est encore très épais au moment de l'arrêt du bombardement ionique et doit être enlevé chimiquement.

La Figure 7D montre le film mince 107 de Ni₈₀ Fe₂₀ restant à la fin de l'étape précédente.

On dépose ensuite une couche d'isolant 108 (espaceur) tel que Si₃ N₄ ou SiO de manière à isoler électriquement les antennes qui vont être ensuite déposées au-dessus des motifs magnétiques (Figure 7E).

Les Figures 7F à 7J montrent les différentes étapes d'une deuxième lithographie optique permettant le dépôt des antennes.

A l'étape de la Figure 7F, la lampe ultraviolette 105 éclaire une couche de résine photosensible inversible 110 recouverte d'un masque 111 et déposée préalablement sur la couche d'isolant 108.

A l'étape de la Figure 7G, après retrait du masque 111, l'échantillon est chauffé, ce qui induit une deuxième dégradation de l'agent photosensible déjà transformé par la lumière : la molécule obtenue devient inhibitrice de dissolution, mais n'est plus sensible à la lumière: Tout l'échantillon peut ensuite être insolé, de manière à rendre très solubles les zones initialement protégées par les motifs métalliques du masque.

A l'étape de la Figure 7H, après le développement et attaque des zones 113 précédemment protégées par le masque 111, on obtient une image négative du masque.

On notera que lors de l'étape de la Figure 7F, l'absorption de la lumière par la résine pendant la première exposition conduit à une insolation plus importante de la partie supérieure. C'est donc cette zone qui sera la plus insoluble au cours du développement de l'étape de la Figure 7H. La partie inférieure de la résine 110 peut ainsi être dissoute un peu plus pour former un profil avec des tranchées 113 présentant une forme évasée vers le bas.

Les étapes des Figures 7I et 7J sont des étapes d'un procédé dit de "lift off" dans lequel on commence par déposer la couche 114, 115 (d'argent ou de cuivre) devant former les antennes au-dessus de l'ensemble de l'échantillon. L'échantillon est ensuite plongé dans un solvant afin de dissoudre la résine 110 et de ne conserver du matériau métallique 114 que sur les zones initialement dégagées par les tranchées 113.

On notera que si les espaceurs 108 sont transparents, les masques 111 des antennes peuvent facilement être alignés par rapport aux motifs magnétiques 107.

D'autres procédés de fabrication de dispositifs hyperfréquence intégrés conformes à l'invention permettant de réaliser des films minces de matériau ferromagnétique conducteur associés à des antennes coplanaires à couplage inductif peuvent naturellement être mis en oeuvre à partir des techniques de la microélectronique. En particulier, le substrat 1 supportant la couche ferromagnétique 2 peut être réalisé à base de silicium.

## Revendications

1. Dispositif intégré à ondes magnétostatiques, comprenant un substrat (1), un film mince ferromagnétique (2) conducteur, ce film mince (2) étant disposé sur ledit substrat (1), une première antenne transductrice (10) de réception de signaux électriques hyperfréquences, disposée parallèlement audit film mince ferromagnétique (2) à proximité de celui-ci pour créer dans ce matériau, par couplage inductif, des ondes magnétostatiques ou des ondes de spin, et une deuxième antenne transductrice (20) d'émission de signaux électriques hyperfréquences, disposée parallèlement audit film mince ferromagnétique (2) à proximité de celui-ci pour être couplée inductivement et délivrer des signaux électriques hyperfréquences lors de l'arrivée d'une onde-magnétostatique dans le film mince ferromagnétique (2), ladite deuxième antenne (20) étant située du même côté du film mince ferromagnétique (2) que la première antenne (10) de façon essentiellement coplanaire à cette dernière, ledit dispositif étant **caractérisé en ce que** l'épaisseur (e₂) du film mince ferromagnétique conducteur est comprise entre environ 250 et 450 nm et de préférence de l'ordre de 300 nanomètres.

2. Dispositif selon la revendication 1, 1, **caractérisé en ce que** le film mince ferromagnétique (2) est en un alliage magnétique dont l'aimantation à saturation est supérieure ou égale à 0,6 T.

3. Dispositif selon la revendication **caractérisé en ce que** le film mince ferromagnétique (2) est en un alliage magnétique très doux tel que Ni₈₀ Fe₂₀.

4. Dispositif selon l'une quelconque des revendications 1 à 3, **caractérisé en ce que** le film mince ferromagnétique (2) présente une largeur (L) de l'ordre de quelques dizaines de micromètres.

5. Dispositif selon l'une quelconque des revendications 1 à 4, **caractérisé en ce que** la distance (e₃) entre d'une part les première et deuxième antennes transductrices (10, 20) et d'autre part le film mince ferromagnétique (2) est de l'ordre de quelques dizaines à quelques centaines de nanomètres.

6. Dispositif selon l'une quelconque des revendications 1 à 5, **caractérisé en ce que** la distance d'écartement (D) entre les première et deuxième antennes transductrices (10, 20) est comprise entre environ 30 et 100 micromètres et de préférence voisine de 40 micromètres.

7. Dispositif selon l'une quelconque des revendications 1 à 6, **caractérisé en ce que** les première et deuxième antennes transductrices (10, 20) comprennent une âme centrale (31) et deux conducteurs latéraux de masse (32, 33) parallèles à l'âme centrale (31) et situés sans contact de part et d'autre de celle-ci.

8. Dispositif selon la revendication 7, **caractérisé en ce que** l'âme centrale présente une largeur de l'ordre de quelques micromètres.

9. Dispositif selon la revendication 6, **caractérisé en ce que** chacune des première et deuxième antennes transductrices (10, 20) s'étend sur toute la largeur (L) du film mince ferromagnétique (2) et occupe dans le sens longitudinal de ce film un espace dont la largeur est inférieure à ladite distance d'écartement (D) et est compris entre environ 10 et 60 micromètres.

10. Dispositif selon l'une quelconque des revendications 1 à 9, **caractérisé en ce que** l'une au moins des première et deuxième antennes transductrices (10, 20) présente une forme de serpentin avec une succession de branches s'étendant dans le sens de la largeur (L) du film mince ferromagnétique (2).

11. Dispositif selon l'une quelconque des revendications 1 à 10, **caractérisé en ce que** chacune des première et deuxième antennes transductrices (10, 20) présente une longueur inférieure au quart de la longueur d'onde des ondes hyperfréquences.

12. Dispositif selon l'une quelconque des revendications 1 à 11, **caractérisé en ce que** la fréquence des ondes hyperfréquences est comprise entre environ 1 GHz et 100 GHz.

13. Dispositif selon l'une quelconque des revendications 1 à 12, **caractérisé en ce qu'**il est réalisé de façon intégrée avec un substrat (1) semiconducteur.

14. Dispositif selon l'une quelconque des revendications 1 à 13, **caractérisé en ce qu'**il comprend une troisième antenne transductrice (30) disposée parallèlement audit film mince ferromagnétique (2) à proximité de celui-ci pour être couplée inductivement et délivrer des signaux électriques hyperfréquences lors de l'arrivée d'une onde magnétostatique dans le film mince ferromagnétique (2), ladite troisième antenne (30) étant située du même côté du film mince ferromagnétique (2) que les première et deuxième antennes (10, 20) en étant interposée entre celles-ci de façon coplanaire.

15. Dispositif selon l'une quelconque des revendications 1 à 14, **caractérisé en ce qu'**il est appliqué à un atténuateur ou un commutateur commandable par un courant et **en ce qu'**il comprend en outre des premiers moyens (5) d'application d'un champ magnétique (H_{A}) transversal dans le sens de la largeur (L) du film mince ferromagnétique (2), des seconds moyens (6) d'application d'un champ magnétique (H_{B}) longitudinal dans le sens de la longueur du film mince ferromagnétique (2) et des moyens de commande d'au moins l'un des premiers et deuxièmes moyens (5, 6) d'application d'un champ magnétique pour modifier sélectivement les caractéristiques du champ magnétique résultant (H_{R}) agissant sur le film mince ferromagnétique (2).

16. Dispositif selon l'une quelconque des revendications 1 à 14, **caractérisé en ce qu'**il est appliqué à un isolateur ou un circulateur et **en ce qu'**il comprend des moyens pour orienter un champ magnétique appliqué au film mince ferromagnétique (2) de telle manière qu'il y ait non réciprocité des première et deuxième antennes transductrices (10, 20), un signal d'ondes magnétostatiques n'étant transmis de façon significative que de la première antenne (10) vers la seconde antenne (20).

17. Dispositif selon la revendication 1, **caractérisé en ce qu'**il est appliqué à un commutateur commandable par un courant, **en ce que** le film mince ferromagnétique conducteur (2) est en un matériau présentant par anisotropie cubique plusieurs états stables à résonance et **en ce qu'**il comprend en outre des moyens d'application d'impulsions de champ magnétique pour faire basculer le film mince d'un état stable à l'autre.

## Claims

1. An integrated magnetostatic wave device, comprising a substrate (1), a conductive ferromagnetic thin film (2), said thin film (2) being deposited on said substrate (1), a first transducer antenna (10) for receiving microwave electrical signals disposed parallel to said ferromagnetic thin film (2) in the vicinity thereof in order to create magnetostatic waves or spin waves in said material by inductive coupling, and a second transducer antenna (20) for transmitting microwave electrical signals disposed parallel to said ferromagnetic thin film (2) in the vicinity thereof in order to be inductively coupled thereto and in order to deliver microwave electrical signals on the arrival of a magnetostatic wave in the ferromagnetic thin film (2), said second antenna (20) being situated on the same side of the ferromagnetic thin film (2) as the first antenna (10) so as to be essentially coplanar therewith, said device being **characterized in that** the thickness e₂ of the conductive ferromagnetic thin film lies in the range about 250 nm to 450 nm and preferably is equal to about 300 nm.

2. A device according to claim 1, **characterized in that** the ferromagnetic thin film (2) is a magnetic alloy having saturated magnetization greater than or equal to 0.6 T.

3. A device according to claim 1, **characterized in that** the ferromagnetic thin film (2) is a very soft magnetic alloy such as Ni₈₀Fe₂₀.

4. A device according to any one of claims 1 to 3, **characterized in that** the ferromagnetic thin film (2) is of width (L) of the order of a few tens of micrometers.

5. A device according to any one of claims 1 to 4, **characterized in that** the distance (e₃) between the ferromagnetic thin film (2) and either of the first and second transducer antennas (10, 20) is of the order of a few tens to a few hundreds of nanometers.

6. A device according to any one of claims 1 to 5, **characterized in that** the spacing distance (D) between the first and second transducer antennas (10, 20) lies in the range about 30 µm to about 100 µm and is preferably close to 40 µm.

7. A device according to any one of claims 1 to 6, **characterized in that** the first and second transducer antennas (10, 20) each comprise a central core (31) and two lateral ground conductors (32, 33) parallel to the central core (31) and situated on either side thereof without making contact therewith.

8. A device according to claim 7, **characterized in that** the central core presents a width of the order of a few micrometers.

9. A device according to claim 6, **characterized in that** each of the first and second transducer antennas (10, 20) extends across the entire width (L) of the ferromagnetic thin film (2) and, in the longitudinal direction of said film, occupies a space of width that is less than said spacing distance (D) and lies in the range about 10 µm to about 60 µm.

10. A device according to any one of claims 1 to 9, **characterized in that** at least one of the first and second transducer antennas (10, 20) is of sinuous shape having a succession of branches extending across the width direction (L) of the ferromagnetic thin film (2).

11. A device according to any one of claims 1 to 10, **characterized in that** each of the first and second transducer antennas (10, 20) is of length shorter than one-fourth of the wavelength of the microwaves.

12. A device according to any one of claims 1 to 11, **characterized in that** the frequency of the microwaves lies in the range about 1 GHz to about 100 GHz.

13. A device according to any one of claims 1 to 12, **characterized in that** it is made in integrated manner on a semiconductor substrate (1).

14. A device according to any one of claims 1 to 13, **characterized in that** it includes a third transducer antenna (30) disposed parallel to said ferromagnetic thin film (2) in the vicinity thereof so as to be inductively coupled thereto and deliver microwave electrical signals on the arrival of a magnetostatic wave in the ferromagnetic thin film (2), said third antenna (30) being situated on the same side of the ferromagnetic thin film (2) as the first and second antennas (10, 20) and being interposed in coplanar manner between them.

15. A device according to any one of claims 1 to 14, **characterized in that** it is applied to a current-controlled attenuator or switch, and **in that** it further comprises first means (5) for applying a transverse magnetic field (H_{A}) in the width direction (L) of the ferromagnetic thin film (2), second means (6) for applying a longitudinal magnetic field (H_{B}) in the length direction of the ferromagnetic thin film (2), and control means for controlling at least one of the first and second means (5, 6) for applying a magnetic field in order to modify selectively the characteristics of the resultant magnetic field (H_{R}) acting on the ferromagnetic thin film (2).

16. A device according to any one of claims 1 to 14, **characterized in that** it is applied to an isolator or a circulator, and **in that** it includes means for directing the magnetic field applied to the ferromagnetic thin film (2) in such a manner as to obtain non-reciprocity between the first and second transducer antennas (10, 20), a magnetostatic wave signal being conveyed in significant manner only from the first antenna (10) towards the second antenna (20).

17. A device according to claim 1, **characterized in that** it is applied to a current control switch, **in that** the conductive ferromagnetic thin film (2) is made of a material presenting cubic anisotropy having a plurality of stable states at resonance, and **in that** it further comprises means for applying magnetic field pulses in order to cause the thin film to switch from one stable state to the other.

## Patentansprüche

1. Integrierte Vorrichtung mit magnetostatischen Wellen, umfassend ein Substrat (1), eine leitende ferromagnetische Dünnschicht (2), wobei diese Dünnschicht (2) auf dem Substrat (1) angeordnet ist, eine erste Wandlerantenne (10) zum Empfangen von elektrischen Mikrowellensignalen, die parallel zu der ferromagnetischen Dünnschicht (2) in deren Nähe angeordnet ist, um in diesem Material mittels induktiver Kopplung magnetostatische Wellen oder Spinwellen zu erzeugen, sowie eine zweite Wandlerantenne (20) zum Senden von elektrischen Mikrowellensignalen, die parallel zu der ferromagnetischen Dünnschicht (2) in deren Nähe angeordnet ist, um induktiv gekoppelt zu werden und um bei Eintreffen einer magnetostatischen Welle in der ferromagnetischen Dünnschicht (2) elektrische Mikrowellensignale zu liefern, wobei die zweite Antenne (20) auf der gleichen Seite der ferromagnetischen Dünnschicht (2) wie die erste Antenne (10) im wesentlichen koplanar zu letzterer angeordnet ist, wobei die Vorrichtung **dadurch gekennzeichnet ist, daß** die Dicke (e₂) der leitenden ferromagnetischen Dünnschicht im Bereich zwischen etwa 250 und 450 nm und vorzugsweise in der Größenordnung von 300 Nanometern liegt.

2. Vorrichtung nach Anspruch 1, **dadurch gekennzeichnet, daß** die ferromagnetische Dünnschicht (2) aus einer magnetischen Legierung besteht, deren Sättigungsmagnetisierung mehr als oder gleich 0,6 T beträgt.

3. Vorrichtung nach Anspruch 1, **dadurch gekennzeichnet, daß** die ferromagnetische Dünnschicht (2) aus einer sehr weichen magnetischen Legierung, wie Ni₈₀Fe₂₀ besteht.

4. Vorrichtung nach einem der Ansprüche 1 bis 3, **dadurch gekennzeichnet, daß** die ferromagnetische Dünnschicht (2) eine Breite (L) in der Größenordnung von einigen zehn Mikrometern aufweist.

5. Vorrichtung nach einem der Ansprüche 1 bis 4, **dadurch gekennzeichnet, daß** der Abstand (e₃) zwischen einerseits der ersten und der zweiten Wandlerantenne (10, 20) und andererseits der ferromagnetischen Dünnschicht (2) in der Größenordnung von einigen zehn bis einigen hundert Nanometern liegt.

6. Vorrichtung nach einem der Ansprüche 1 bis 5, **dadurch gekennzeichnet, daß** der Abstand (D) zwischen der ersten und der zweiten Wandlerantenne (10, 20) zwischen etwa 30 und 100 Mikrometern und vorzugsweise nahe 40 Mikrometern liegt.

7. Vorrichtung nach einem der Ansprüche 1 bis 6, **dadurch gekennzeichnet, daß** die erste und die zweite Wandlerantenne (10, 20) einen mittleren Kern (31) und zwei seitliche Masseleiter (32, 33), die parallel zu dem mittleren Kern (31) verlaufen und auf dessen beiden Seiten kontaktlos angeordnet sind, umfassen.

8. Vorrichtung nach Anspruch 7, **dadurch gekennzeichnet, daß** der mittlere Kern eine Breite in der Größenordnung von einigen Mikrometern aufweist.

9. Vorrichtung nach Anspruch 6, **dadurch gekennzeichnet, daß** eine jede der ersten und zweiten Wandlerantennen (10, 20) sich über die gesamte Breite (L) der ferromagnetischen Dünnschicht (2) erstreckt und in Längsrichtung dieser Schicht einen Raum einnimmt, dessen Breite geringer als der Abstand (D) ist und zwischen etwa 10 und 60 Mikrometern liegt.

10. Vorrichtung nach einem der Ansprüche 1 bis 9, **dadurch gekennzeichnet, daß** wenigstens eine der ersten und zweiten Wandlerantennen (10, 20) eine Schlangenform mit einer Folge von Zweigen, die in Richtung der Breite (L) der ferromagnetischen Dünnschicht (2) verlaufen, aufweist.

11. Vorrichtung nach einem der Ansprüche 1 bis 10, **dadurch gekennzeichnet, daß** eine jede der ersten und zweiten Wandlerantennen (10, 20) eine Länge aufweist, die kleiner als das Viertel der Wellenlänge der Mikrowellen ist.

12. Vorrichtung nach einem der Ansprüche 1 bis 11, **dadurch gekennzeichnet, daß** die Frequenz der Mikrowellen im Bereich zwischen etwa 1 GHz und 100 GHz liegt.

13. Vorrichtung nach einem der Ansprüche 1 bis 12, **dadurch gekennzeichnet, daß** sie mit einem Halbleitersubstrat (1) integriert ausgebildet ist.

14. Vorrichtung nach einem der Ansprüche 1 bis 13, **dadurch gekennzeichnet, daß** sie eine dritte Wandlerantenne (30) umfaßt, die parallel zu der ferromagnetischen Dünnschicht (2) in deren Nähe angeordnet ist, um induktiv gekoppelt zu werden und um bei Eintreffen einer magnetostatischen Welle in der ferromagnetischen Dünnschicht (2) elektrische Mikrowellensignale zu liefern, wobei die dritte Antenne (30) auf der gleichen Seite der ferromagnetischen Dünnschicht (2) wie die erste und die zweite Antenne (10, 20) gelegen und dabei zwischen diesen koplanar eingefügt ist.

15. Vorrichtung nach einem der Ansprüche 1 bis 14, **dadurch gekennzeichnet, daß** sie auf einen Dämpfer oder einen Schalter, welcher durch einen Strom steuerbar ist, angewandt ist und daß sie ferner erste Mittel (5) zum Anlegen eines Quermagnetfeldes (H_{A}) in Richtung der Breite (L) der ferromagnetischen Dünnschicht (2), zweite Mittel (6) zum Anlegen eines Längsmagnetfeldes (H_{B}) in Richtung der Länge der ferromagnetischen Dünnschicht (2) sowie Mittel zum Steuern von wenigstens einem der ersten und zweiten Mittel (5, 6) zum Anlegen eines Magnetfeldes umfaßt, um die Eigenschaften des resultierenden Magnetfeldes (H_{R}), welches auf die ferromagnetische Dünnschicht (2) wirkt, selektiv zu verändern.

16. Vorrichtung nach einem der Ansprüche 1 bis 14, **dadurch gekennzeichnet, daß** sie auf einen Isolator oder einen Zirkulator angewandt ist und daß sie Mittel umfaßt, um ein an die ferromagnetische Dünnschicht (2) angelegtes Magnetfeld derart auszurichten, daß Nichtreziprozität der ersten und der zweiten Wandlerantenne (10, 20) gegeben ist, wobei ein Signal magnetostatischer Wellen lediglich von der ersten Antenne (10) zur zweiten Antenne (20) signifikant übertragen wird.

17. Vorrichtung nach Anspruch 1, **dadurch gekennzeichnet, daß** sie auf einen durch einen Strom steuerbaren Schalter angewandt ist, daß die leitende ferromagnetische Dünnschicht (2) aus einem Material besteht, das durch kubische Anisotropie mehrere stabile Resonanzzustände aufweist, und daß sie ferner Mittel zum Anlegen von Magnetfeldimpulsen umfaßt, um die Dünnschicht von einem stabilen Zustand in einen anderen zu überführen.
